# EUROPEAN PATENT APPLICATION

(11) **EP 4 770 380 A1**
(43) Date of publication of application: **01.07.2026**
(21) Application number: 25215772.2
(22) Date of filing: 14.11.2025
(51) Int. Cl.: H10K 59/131

(54) **DISPLAY DEVICE AND WATCH PHONE INCLUDING THE SAME**

(30) Priority: 31.12.2024 KR 20240202051
(71) Applicant: LG Display Co., Ltd., Seoul, 07336 (KR)
(72) Inventor: HA, Jongmoo, 10845 Paju-si (KR); LEE, Soobin, 10845 Paju-si (KR)
(74) Representative: Ter Meer Steinmeister & Partner

(57) **Abstract**

Disclosed is a display device including: a substrate including a display area and a non-display area surrounding the display area; a bendable area disposed in the non-display area; a link area disposed between the display area and the bendable area, wherein an organic insulating structure including an inclined side surface is disposed on the link area; a first signal line disposed on the link area; and a second signal line disposed on the link area, wherein an isolation space is defined between the first signal line and the second signal line of the display device, wherein the isolation space is disposed in a region different from a region where the inclined side surface of the organic insulating structure is disposed.

## Description

### BACKGROUND OF THE DISCLOSURE

### FIELD

The present disclosure relates to a display device and watch phone including the same.

### DESCRIPTION OF RELATED ART

A display device is applied to various electronic devices such as a TV, a smartphone, a laptop computer, and a tablet. To this end, research is being conducted to develop a thin, light weight, and low power consuming display device.

A bezel area of the display device may be visually recognized by the user and may be a factor that degrades the sense of immersion in the image emitted from the display area. Accordingly, there is an increasing demand for a display device that implements a narrow bezel that enlarges a display area and reduces a bezel area in which a screen is not displayed, or a zero bezel that substantially has an effect of not having a bezel area.

The organic light-emitting diode display (OLED) device as a self-light-emitting device may be made with a thinner profile than, e.g., a liquid crystal display (LCD) device. Accordingly, it is easy to fold or bend the OLED deice using a substrate made of a flexible material.

Recently, as the demand and use of wearable devices, especially watch phones, increase, research on applying the organic light-emitting display devices to the watch phones is also increasing.

### SUMMARY OF THE DISCLOSURE

It is an object to provide a display device capable of preventing a crack from occurring in an organic insulating layer in a non-display area adjacent to a display area, thereby preventing moisture from penetrating into a signal line through the crack.

It is another object to provide a display device capable of preventing signal lines from coming into contact with each other and thus being short-circuited with each other in a non-display area in which an entry area of the signal lines for transmitting a signal or power to the display area is located.

It is another object to provide a display device capable of preventing a low potential power (VSS) line and a high potential power (VDD) line disposed close to each other in the link area from coming into contact with each other and thus being short-circuited with each other.

It is another object to provide a display device including a robust structure by which signal lines may maintain stable and reliable performance under external environmental changes or conditions in a non-display area in which the entry area of the signal lines is located.

It is another object to provide a display device capable of preventing the signal lines from being corroded or preventing the short-circuit between the signal lines to reduce a defect rate of the display device, thereby preventing an increase in production energy required for the production of the display device, and thus reducing the emission of greenhouse gas.

It is another object to provide a display device capable of stably maintaining the performance of a watch phone by preventing signal lines for controlling the operation of the watch phone from contacting each other and thus being short-circuited therebetween in a narrow bezel area.

The object is solved by the features of the independent claims. Preferred embodiments are given in the dependent claims.

To this end, a display device according to one embodiment of the disclosure includes: a substrate including a display area and a non-display area surrounding the display area; a bendable area disposed in the non-display area; a link area disposed between the display area and the bendable area, wherein an organic insulating structure including an inclined side surface is disposed on the link area; a first signal line disposed on the link area; and a second signal line disposed on the link area, wherein an isolation space is defined between the first signal line and the second signal line of the display device, wherein the isolation space is disposed in a region different from a region where the inclined side surface of the organic insulating structure is disposed.

In one or more embodiments, the first signal line may include a low potential power (VSS) line.

In one or more embodiments, the second signal line may include a high potential power (VDD) line.

In one or more embodiments, the organic insulating structure including the inclined side surface may include: a first planarization layer disposed on the substrate and extending from the display area; a second planarization layer disposed on the first planarization layer; a bank disposed on the second planarization layer; and a first barrier structure disposed on the bank.

In one or more embodiments, a side end of the second planarization layer may include an inclined side surface having an inclination.

In one or more embodiments, the isolation space may be positioned inwardly of the side end of the second planarization layer and may vertically non-overlap the inclined side surface of the second planarization layer.

In one or more embodiments, the link area may include: a first area on which the organic insulating structure is disposed; a third area spaced apart from the first area and a second area disposed between the first area and the third area.

In one or more embodiments, a dam may be disposed on the third area.

In one or more embodiments, a second barrier structure may be disposed on the second area and includes a plurality of structures spaced apart from each other.

In one or more embodiments, the plurality of structures may include a first barrier disposed adjacent to the organic insulating structure; and a second barrier disposed adjacent to the dam.

In one or more embodiments, each of the first barrier and the second barrier may have an island pattern shape.

In one or more embodiments, each of the first barrier and the second barrier may include an inclined side surface.

In one or more embodiments, the second barrier structure may include an organic insulating material.

In one or more embodiments, the isolation space may be disposed to overlap the plurality of structures in the second area.

In one or more embodiments, the isolation space may overlap one inclined side surface of each of the first barrier and the second barrier.

In one or more embodiments, each of a side end of the first signal line and a side end of the second signal line may have an inclined side surface.

In one or more embodiments, the inclined side surface of the first signal line may vertically overlap the inclined side surface of the first barrier.

In one or more embodiments, the inclined side surface of the second signal line may vertically overlap the inclined side surface of the second barrier.

In one or more embodiments, a third barrier structure having one island pattern shape may be disposed on the second area.

In one or more embodiments, the third barrier structure may include an organic insulating material.

In one or more embodiments, the third barrier structure may include an upper surface, a lower surface and an inclined side surface extending between the upper surface and the lower surface.

In one or more embodiments, the isolation space may vertically non-overlap the inclined side surface of the third barrier structure.

In one or more embodiments, the first signal line may include a first overlapping area overlapping an inclined side surface of one side of the third barrier structure.

In one or more embodiments, the second signal line may include a second overlapping area overlapping an inclined side surface of the other side of the third barrier structure.

In one or more embodiments, the display device may further comprise a barrier reinforcement pattern disposed on a portion of the organic insulating structure disposed on the first area.

In one or more embodiments, the display device may further comprise a barrier reinforcement pattern continuously extending from one of the plurality of structures disposed spaced apart from each other in the second area to another structure.

In one or more embodiments, the barrier reinforcement pattern may include a metal material.

In one or more embodiments, the second barrier structure includes a same organic insulating material included in the organic insulating structure.

In one or more embodiments, the inclined side surface of the organic insulating structure overlapping the first signal line or the second signal line.

In one or more embodiments, the isolation space is disposed to overlap the plurality of barriers in the second area.

In one or more embodiments, each of a space between the third barrier structure and the organic insulating structure and a space between the third barrier structure and the dam overlaps the first signal line or the second signal line.

In one or more embodiments, the barrier reinforcement pattern on the third barrier structure in the second area and including a metal material.

According to an embodiment of the disclosure, the isolation space defined between the signal lines disposed in the signal line entry area of the display area is positioned so as not to vertically overlap the side end of the organic insulating layer extending from the display area, thereby preventing an increase in the strain of the organic insulating layer.

Accordingly, the robust structure that prevents cracks or breakage defects from occurring at the organic insulating layer can be implemented, thereby preventing moisture from penetrating through the cracks and corroding the signal line. Accordingly, the signal or power provided for the operation of the pixel may be stably provided, such that the product reliability may be improved.

According to an embodiment of the present disclosure, the isolation space defined between the signal lines is disposed in the signal line entry area of the display area, thereby preventing contact between adjacent signal lines. Accordingly, there is an effect of preventing the short-circuit between the adjacent signal lines.

According to embodiments of the disclosure, a defect rate of a display device due to corrosion of signal lines or a short-circuit between signal lines is reduced, and thus production energy required for the production of the display device may be reduced, thereby reducing greenhouse gas emission.

According to embodiments of the disclosure, the isolation space defined between the signal lines is disposed in a narrow bezel area in which the signal lines for controlling the operation of the watch phone are disposed, thereby preventing the signal lines from contacting each other and thus being short-circuited therebetween. Accordingly, there is an effect of stably maintaining the performance of the watch phone.

Effects of the disclosure are not limited to the effects mentioned above, and other effects not mentioned will be clearly understood by those skilled in the art from the description as set forth below.

In addition to the above effects, specific effects of the disclosure are described together while describing specific details for carrying out the disclosure.

### BRIEF DESCRIPTION OF THE DRAWINGS

FIG. 1 is a plan view of a display panel according to embodiments of the present disclosure.
FIG. 2 is a cross-sectional view taken along a line I-I' in FIG. 1 according to embodiments of the present disclosure.
FIG. 3 is an enlarged view of an area II of FIG. 1.
FIG. 4 is a diagram according to a first embodiment of the present disclosure.
FIGS. 5 and 6 are diagrams according to a second embodiment of the present disclosure.
FIG. 7 is a diagram according to a third embodiment of the present disclosure.
FIGS. 8 and 9 are diagrams according to a fourth embodiment of the present disclosure.
FIGS. 10 and 11 are diagrams according to a fifth embodiment of the present disclosure.
FIGS. 12 to 14 are diagrams according to still further embodiments of the present disclosure.

### DETAILED DESCRIPTION OF THE DISCLOSURE

Advantages and Advantages and features of the disclosure, and a method of achieving the advantages and features will become apparent with reference to embodiments described later in detail together with the accompanying drawings. However, the present disclosure is not limited to the embodiments as disclosed under, but may be implemented in various different forms. Thus, these embodiments are set forth only to make the present disclosure complete, and to completely inform the scope of the disclosure to those of ordinary skill in the technical field to which the present disclosure belongs, and the disclosure is only defined by the scope of the claims.

For simplicity and clarity of illustration, elements in the drawings are not necessarily drawn to scale. The same reference numbers in different drawings represent the same or similar elements, and as such perform similar functionality. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure. Examples of various embodiments are illustrated and described further below. It will be understood that the description herein is not intended to limit the claims to the specific embodiments described. On the contrary, it is intended to cover alternatives, modifications, and equivalents as may be included within the spirit and scope of the present disclosure as defined by the appended claims.

A shape, a size, a ratio, an angle, a number, etc. disclosed in the drawings for illustrating embodiments of the present disclosure are illustrative, and the present disclosure is not limited thereto.

The terminology used herein is directed to the purpose of describing particular embodiments only and is not intended to be limiting of the present disclosure. As used herein, the singular constitutes "a" and "an" are intended to include the plural constitutes as well, unless the context clearly indicates otherwise. It will be further understood that the terms "comprise", "comprising", "include", and "including" when used in this disclosure, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of associated listed items. Expression such as "at least one of" when preceding a list of elements may modify the entire list of elements and may not modify the individual elements of the list. In interpretation of numerical values, an error or tolerance therein may occur even when there is no explicit description thereof.

In addition, it will also be understood that when a first element or layer is referred to as being present "on" a second element or layer, the first element may be disposed directly on the second element or may be disposed indirectly on the second element with a third element or layer being disposed between the first and second elements or layers. It will be understood that when an element or layer is referred to as being "connected to", or "coupled to" another element or layer, it may be directly connected to, or coupled to the other element or layer, or one or more intervening elements or layers may be present therebetween. In addition, it will also be understood that when an element or layer is referred to as being "between" two elements or layers, it may be the only element or layer between the two elements or layers, or one or more intervening elements or layers may also be present.

Further, as used herein, when a layer, film, area, plate, or the like is disposed "on" or "on top" of another layer, film, area, plate, or the like, the former may directly contact the latter or still another layer, film, area, plate, or the like may be disposed between the former and the latter. As used herein, when a layer, film, area, plate, or the like is directly disposed "on" or "on top" of another layer, film, area, plate, or the like, the former directly contacts the latter and still another layer, film, area, plate, or the like is not disposed between the former and the latter. Further, as used herein, when a layer, film, area, plate, or the like is disposed "beneath" or "under" another layer, film, area, plate, or the like, the former may directly contact the latter or still another layer, film, area, plate, or the like may be disposed between the former and the latter. As used herein, when a layer, film, area, plate, or the like is directly disposed "beneath" or "under" another layer, film, area, plate, or the like, the former directly contacts the latter and still another layer, film, area, plate, or the like is not disposed between the former and the latter.

In descriptions of temporal relationships, for example, temporal precedent relationships between two events such as "after", "subsequent to", "before", etc., another event may occur therebetween unless "directly after", "directly subsequent" or "directly before" is not indicated.

When a certain embodiment may be implemented differently, a function or an operation specified in a specific block may occur in a different order from an order specified in a flowchart. For example, two blocks in succession may be actually performed substantially concurrently, or the two blocks may be performed in a reverse order depending on a function or operation involved.

It will be understood that, although the terms "first", "second", "third", and so on may be used herein to describe various elements, components, areas, layers and/or periods, these elements, components, areas, layers and/or periods should not be limited by these terms. These terms are used to distinguish one element, component, area, layer or section from another element, component, area, layer or period. Thus, a first element, component, area, layer or section as described under could be termed a second element, component, area, layer or period, without departing from the spirit and scope of the present disclosure.

When an embodiment may be implemented differently, functions or operations specified within a specific block may be performed in a different order from an order specified in a flowchart. For example, two consecutive blocks may actually be performed substantially simultaneously, or the blocks may be performed in a reverse order depending on related functions or operations.

The features of the various embodiments of the present disclosure may be partially or entirely combined with each other, and may be technically associated with each other or operate with each other. The embodiments may be implemented independently of each other and may be implemented together in an association relationship.

In interpreting a numerical value, the value is interpreted as including an error range unless there is no separate explicit description thereof.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, "embodiments," "examples," "aspects, and the like should not be construed such that any aspect or design as described is superior to or advantageous over other aspects or designs.

Further, the term 'or' means 'inclusive or' rather than 'exclusive or'. That is, unless otherwise stated or clear from the context, the expression that 'x uses a or b' means one of natural inclusive permutations.

The terms used in the description below have been selected as being general and universal in the related technical field. However, there may be other terms than the terms depending on the development and/or change of technology, convention, preference of technicians, etc. Therefore, the terms used in the description below should not be understood as limiting technical ideas, but should be understood as examples of the terms for illustrating embodiments.

Further, in a specific case, a term may be arbitrarily selected by the applicant, and in this case, the detailed meaning thereof will be described in a corresponding description period. Therefore, the terms used in the description below should be understood based on not simply the name of the terms, but the meaning of the terms and the contents throughout the Detailed Descriptions.

In description of flow of a signal, for example, when a signal is delivered from a node A to a node B, this may include a case where the signal is transferred from the node A to the node B via another node unless a phrase 'immediately transferred' or 'directly transferred' is used.

Throughout the present disclosure, "A and/or B" means A, B, or A and B, unless otherwise specified, and "C to D" means C inclusive to D inclusive unless otherwise specified.

"At least one" should be understood to include any combination of one or more of listed components. For example, at least one of first, second, and third components means not only a first, second, or third component, but also all combinations of two or more of the first, second, and third components.

Hereinafter, embodiments of the present disclosure will be described using the attached drawings. A scale of each of components as shown in the drawings is different from an actual scale thereof for convenience of illustration, and therefore, the present disclosure is not limited to the scale as shown in the drawings.

As used herein, a first direction, a second direction, and a third direction, or an X-axis direction, a Y-axis direction, and a Z-axis direction should not be interpreted only as having a geometric relationship with each other in which the first direction, the second direction, and the third direction are perpendicular to each other or the X-axis direction, the Y-axis direction, and the Z-axis direction are perpendicular to each other, but may be interpreted as having a geometric relationship with each other in which the first direction, the second direction, and the third direction interest each other at an angle other than 90 degrees (°) or the X-axis direction, the Y-axis direction, and the Z-axis direction are interest each other at an angle other than 90 degrees (°) within a range in which a configuration of the present disclosure may work functionally.

Hereinafter, a display device of an embodiment of the disclosure will be described with reference to the drawings.

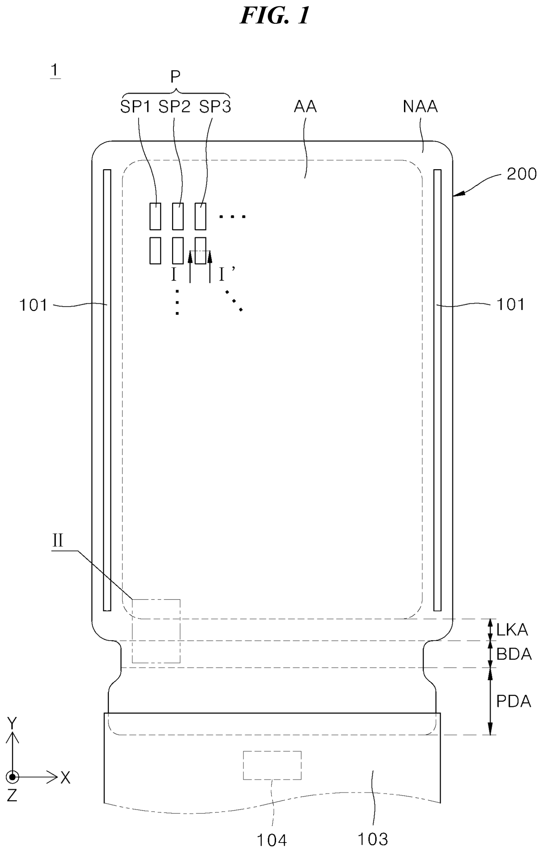

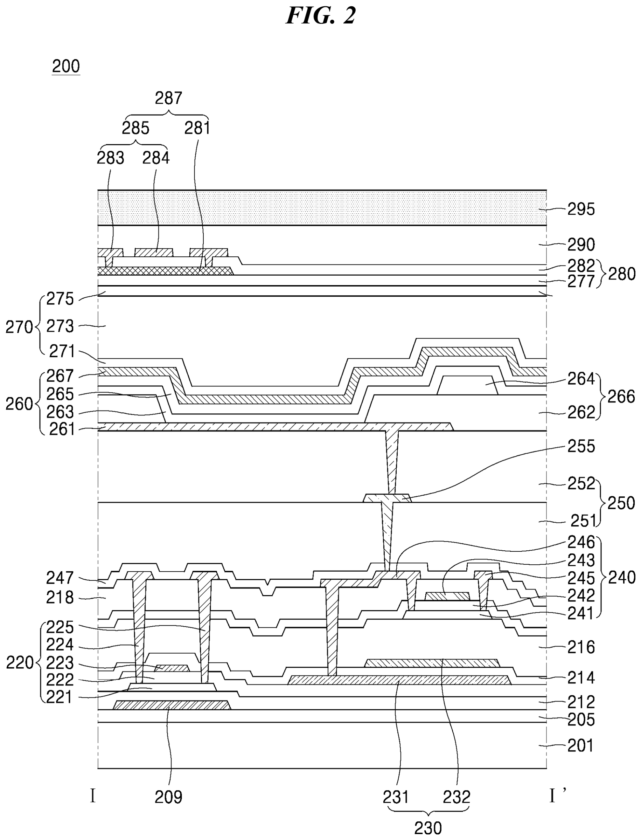

FIG. 1 is a plan view of a display panel according to embodiments of the present disclosure. FIG. 2 is a cross-sectional view taken along a line I-I' in FIG. 1.

Referring to FIGS. 1 and 2, a display device 1 of an embodiment of the disclosure may include a display panel 200, a flexible printed circuit board 103, and drivers (driving circuitry for the display panel). The display panel 200 may include a display area AA and a non-display area NAA. The display area AA may be an area in which an image is displayed. The non-display area NAA may be an area in which no image is displayed. In the non display area NAA no image can be displayed. The non-display area NAA may be located in a peripheral area (or edge area) of the display panel 200, preferably it is partly or fully surrounding the display area AA. However, the disclosure is not limited thereto. For example, an area other than a light emission area in which light is emitted to the outside in the display area AA may be referred to as the non-display area NAA. A bezel area of the display device may be defined by the non-display area NAA. The bezel area BZA may surround the periphery of the display area AA. The non-display area NAA may be disposed on an upper side, a left side, a right side, and/or a lower side of the display area AA, and the link area LKA, a bendable area BDA, and a pad area PDA may be disposed in a portion of the non-display area NAA disposed on the lower side of the display area AA.

A plurality of pixels P for displaying an image may be disposed in the display area AA. One pixel P may include a plurality of sub-pixels SP1, SP2, and SP3. The plurality of sub-pixels (including SP1, SP2, and SP3) may be arranged in an array in the display area AA. In an example, the plurality of subpixels (including SP1, SP2, and SP3) may be arranged in a matrix manner and may be spaced apart from each other in the first direction of the display area AA and the second direction intersecting the first direction. The first direction may be a horizontal direction, an X-axis direction, or a row direction, and the second direction may be a vertical direction, a Y-axis direction, or a column direction. However, the present disclosure is not limited thereto, and the arrangement shape, arrangement order, and arrangement direction of the sub-pixels SP1, SP2, and SP3 may be variously changed.

In the disclosure, one pixel P is configured to include the first sub-pixel SP1, the second sub-pixel SP2, and the third sub-pixel SP3. However, the disclosure is not limited thereto. For example, one pixel P may further include an additional sub-pixel.

The sub-pixels SP1, SP2, and SP3 may be implemented to emit light of the same color such as white light. Alternatively, the sub-pixels SP1, SP2, and SP3 may be implemented to emit light of different colors such as red, green, and blue colors. For example, the first sub-pixel SP1 may emit light of red, the second sub-pixel SP2 may emit light of green, and the third sub-pixel SP3 may emit light of blue.

Various lines and circuits for driving the plurality of sub-pixels (e.g., SP1, SP2, SP3) of the display area AA may be disposed in the non-display area NAA. For example, driving circuits including a gate driving circuit and a data driving circuit may be disposed in the non-display area NAA. One or more or several drivers for driving the display area AA may be disposed in the non-display area NAA. For example, the drivers may include a gate driver 101 and a data driver. However, the disclosure is not limited thereto. The gate driver 101 may be disposed in each of left and/or right portions of the non-display area NAA respectively located on the left and/or right sides of the display area AA.

In the pad area PDA disposed on the lower side of the bendable area BDA of the non-display area NAA, a plurality of pads may be disposed. The pads are electrically connected to the flexible printed circuit board 103 on which a driving circuit chip 104 is disposed.

The non-display area NAA may include the link area LKA in which signal lines for transmitting various signals or power provided from the driving circuit chip 104 to the sub-pixels (e.g., SP1, SP2, SP3) of the display area AA are disposed. For example, the link area LKA may be disposed between the display area AA and the bendable area BDA. The bendable area BDA may be disposed between the link area LKA and the pad area PDA. As the link area LKA is adjacent to the display area AA, the link area LKA may also be referred to as an entry area in which the signal lines start to extend from the non-display area NAA into the display area AA. In an example, the display device 1 according to an embodiment of the disclosure may be included in a watch phone.

As a substrate made of a flexible material is applied to the display device, the display panel 200 may include a bendable area BDA in which a portion of the display panel 200 may be bent such that the pad area PDA may be hidden under the display area AA. Accordingly, the bezel area of the display device visually recognized by the user may be reduced.

FIG. 2 schematically illustrates one sub-pixel of a display device taken along line I-I' in FIG. 1. In the disclosure, for convenience of description, an example of a configuration of one sub-pixel is described. However, the disclosure is not limited thereto.

Referring to FIG. 2, the display panel 200 may include a pixel driving circuit including a plurality of transistors 220 and 240 disposed on a substrate 201, a light-emitting element 260, and a touch sensor 287.

One sub-pixel may include a light-emitting element 260 and a pixel driving circuit that applies a driving current to the light-emitting element 260. The pixel driving circuit is disposed on the substrate 201, and the light-emitting element 260 is disposed on the pixel driving circuit. The pixel driving circuit may include a plurality of transistors 220 and 240 and a storage capacitor 230. In an example, the plurality of transistors 220 and 240 may include a first transistor 220 and a second transistor 240.

The substrate 201 may be a flexible plastic substrate. When the substrate 201 is formed as a plastic film, the substrate 201 may include multiple layers made of an insulating material. For example, the substrate 201 may include polyimide (PI).

A first buffer layer 205 may be disposed on the substrate 201. The first buffer layer 205 may cover a surface of the substrate 201. For example, the first buffer layer 205 may extend to the link area LKA. The first buffer layer 205 may reduce or prevent penetration of moisture, oxygen, or impurities through the substrate 201. The first buffer layer 205 may be embodied as a single layer or a multilayer made of an inorganic insulating material such as silicon oxide (SiOx) or silicon nitride (SiNx).

A light-shielding layer 209 may be disposed on the first buffer layer 205. The light-shielding layer 209 may prevent external light from being incident on the transistor TR. To this end, the light-shielding layer 209 may include an opaque metal material. A second buffer layer 212 may be disposed on the light-shielding layer 209. The second buffer layer 212 may protect the transistor TR from moisture, oxygen, or impurities. The second buffer layer 212 may be embodied as a single layer or a multilayer made of an inorganic insulating material such as silicon oxide (SiOx) or silicon nitride (SiNx). However, embodiments of the present disclosure are not limited thereto. The second buffer layer 212 may entirely cover the surface of the substrate 201. For example, the second buffer layer 212 may extend to the non-display area NAA surrounding the periphery of the display area AA.

The first transistor 220 may be disposed on the second buffer layer 212. The first transistor 220 may include a first semiconductor layer 221, a first gate insulating layer 222, a first gate electrode 223, a first source electrode 224, and a first drain electrode 225. In an example, the first transistor 220 may be a switching transistor.

The first semiconductor layer 221 may include a channel area and source/drain areas. An area of the first semiconductor layer 221 overlapping the first gate electrode 223 in the vertical direction may be a channel area. The source/drain areas may be disposed on both opposing sides of the channel area, respectively. The first semiconductor layer 221 may include one of a polysilicon semiconductor layer and a low-temperature polysilicon semiconductor layer, or a combination thereof. In another example, the first semiconductor layer 221 may include an oxide semiconductor layer. For example, the first semiconductor layer 221 may include at least one of an oxide semiconductor material such as IGZO (Indium Gallium Zinc Oxide) or IZO (Indium Zinc Oxide).

When the first semiconductor layer 221 includes the oxide semiconductor layer, the first transistor 220 may be embodied as an oxide thin-film transistor. In this regard, the first transistor 220 may include components respectively made of the same materials as those of components constituting the second transistor 240. For example, the first semiconductor layer 221, the first gate insulating layer 222, the first gate electrode 223, the first source electrode 224, and the first drain electrode 225 constituting the first transistor 220 may be respectively made as the same materials as those of the second semiconductor layer 241, the second gate insulating layer 242, the second gate electrode 243, the second source electrode 245, and the second drain electrode 246 constituting the second transistor 240. The first semiconductor layer 221 may be disposed to overlap the light-shielding layer 209 in the vertical direction. The light-shielding layer 209 may reduce or prevent external light from being incident on the first semiconductor layer 221.

The first gate insulating layer 222 may be disposed between the first semiconductor layer 221 and the first gate electrode 223. The first gate insulating layer 222 may extend outwardly while covering the first semiconductor layer 221. The first gate insulating layer 222 may be embodied as a single layer or a stack of a plurality of layers made of an inorganic insulating material such as silicon oxide (SiOx) or silicon nitride (SiNx).

The first gate electrode 223 may be disposed on the first gate insulating layer 222. A first interlayer insulating layer 214 may be disposed on the first gate electrode 223. The first interlayer insulating layer 214 may be embodied as a single layer or a stack of multiple layers made of an inorganic insulating material such as silicon oxide (SiOx) or silicon nitride (SiNx). In an example, the first interlayer insulating layer 214 may extend to the link area LKA.

The first source electrode 224 and the first drain electrode 225 may be electrically connected to the first semiconductor layer 221.

The storage capacitor 230 may include a first storage electrode 231 and a second storage electrode 232. For example, the first storage electrode 231 and the first gate electrode 223 may be formed on the same layer (e.g., the first gate insulating layer 222).. For example, the first storage electrode 231 may be made of the same material as that of the first gate electrode 223. The first storage electrode 231 may be disposed on the first gate insulating layer 222 and at a position horizontally spaced apart from the first gate electrode 223. The second storage electrode 232 may be disposed on the first interlayer insulating layer 214 so as to overlap the first storage electrode 231 in the vertical direction.

Each of the first storage electrode 231 and the second storage electrode 232 may be embodied as a single layer or as a stack of multiple layers made of one of molybdenum (Mo), aluminum (Al), chromium (Cr), gold (Au), titanium (Ti), nickel (Ni), neodymium (Nd), and copper (Cu) or an alloy thereof. However, the present disclosure is not limited thereto.

A second interlayer insulating layer 216 may be disposed on the second storage electrode 232. The second interlayer insulating layer 216 may be embodied as a single layer or a stack of multiple layers made of an inorganic insulating material such as silicon oxide (SiOx) or silicon nitride (SiNx).

The second transistor 240 may be disposed on the second interlayer insulating layer 216 so as to be spaced apart from the first transistor 220. The second transistor 240 may be electrically connected to the first transistor 220. For example, the second transistor 240 may include a second semiconductor layer 241, a second gate insulating layer 242, a second gate electrode 243, a second source electrode 245, and a second drain electrode 246. In an example, the second transistor 240 may be a driving transistor electrically connected to the light-emitting element 260.

The second semiconductor layer 241 may include a channel area and source/drain areas. A area of the second semiconductor layer 241 overlapping the second gate electrode 243 in the vertical direction may be a channel area. The source/drain areas may be disposed on both opposing sides of the channel area, respectively. The second semiconductor layer 241 may include an oxide semiconductor layer. For example, the second semiconductor layer 241 may include at least one of an oxide semiconductor material such as indium gallium zinc oxide (IGZO) or indium zinc oxide (IZO). In an example, the second semiconductor layer 241 may be disposed to overlap the storage capacitor 230 in the vertical direction. Accordingly, the storage capacitor 230 may prevent the external light from the outside out of the substrate 201 from being incident on the second semiconductor layer 241. Accordingly, this may prevent the characteristics of the second transistor 240 from being changed by the external light.

The second gate insulating layer 242 may be disposed between the second semiconductor layer 241 and the second gate electrode 243. The second gate insulating layer 242 may extend outwardly while covering the second semiconductor layer 241. For example, the second gate insulating layer 242 may extend to the link area LKA. The second gate insulating layer 242 may be embodied as a single layer or a stack of a plurality of layers made of an inorganic insulating material such as silicon oxide (SiOx) or silicon nitride (SiNx).

Each of the first gate electrode 223 or the second gate electrode 243 may be embodied as a single layer or a stack of multiple layers made of one of molybdenum (Mo), aluminum (Al), chromium (Cr), gold (Au), titanium (Ti), nickel (Ni), neodymium (Nd), and copper (Cu), or an alloy thereof. However, an example of the material is not limited thereto.

A third interlayer insulating layer 218 may be disposed on the second gate electrode 243. The third interlayer insulating layer 218 may include an insulating material. For example, the third interlayer insulating layer 218 may include an inorganic insulating material such as silicon oxide (Six), silicon nitride (SiNx), or silicon oxynitride (SiON), and may be embodied as a single layer or a stack of multiple layers.

The first source electrode 224, the first drain electrode 225, the second source electrode 245, and the second drain electrode 246 may be disposed on the third interlayer insulating layer 218.

The first source electrode 224 and the first drain electrode 225 may extend through the third interlayer insulating layer 218, the second gate insulating layer 242, the second interlayer insulating layer 216, the first interlayer insulating layer 214, and the first gate insulating layer 222 so as to be in direct contact with and be electrically connected to the source/drain areas of the first semiconductor layer 221, respectively.

The second source electrode 245 and the second drain electrode 246 may extend through the second interlayer insulating layer 218 and the second gate insulating layer 242 so as to directly contact and be electrically connected to the source/drain areas of the second semiconductor layer 241, respectively. The second drain electrode 246 of the second transistor 240 may be electrically connected to the storage capacitor 230. For example, a portion of the second drain electrode 246 may extend through the second interlayer insulating layer 218, the second gate insulating layer 242, the second interlayer insulating layer 216, and the first interlayer insulating layer 214 so as to be in direct contact with and be electrically connected to the first storage electrode 231 of the storage capacitor 230.

Each of the first source electrode 224, the first drain electrode 225, the second source electrode 245, or the second drain electrode 246 may be embodied as a single layer or a stack of multiple layers made of one of molybdenum (Mo), aluminum (Al), chromium (Cr), gold (Au), titanium (Ti), nickel (Ni), neodymium (Nd), and copper (Cu), or an alloy thereof. However, embodiments of the present disclosure are not limited thereto. In an example, each of the first source electrode 224 or the second drain electrode 225 may have a stack structure of titanium layer/aluminum layer/titanium layer (Ti/Al/Ti).

A passivation layer 247 may be disposed on the first source electrode 224, the first drain electrode 225, the second source electrode 245, or the second drain electrode 246. The passivation layer 247 may extend outwardly. For example, the passivation layer 247 may extend to the link area LKA. The passivation layer 247 include an inorganic insulating material such as silicon oxide, silicon nitride, and silicon oxynitride, and may be embodied as a single layer or a stack of multiple layers. The passivation layer 247 may protect the pixel driving circuit disposed thereunder.

A planarization layer 250 may be disposed on the passivation layer 247. The planarization layer 250 may planarize a step caused due to the pixel driving circuit thereunder. The planarization layer 250 may include a multilayer structure of a first planarization layer 251 and a second planarization layer 252. For example, the planarization layer 250 may include an organic insulating material such as polyimide or acrylic resin. In an example, each of the first planarization layer 251 and the second planarization layer 252 may extend to the link area LKA.

A pixel contact electrode 255 may be disposed on the first planarization layer 251. The pixel contact electrode 255 may extend thorough the first planarization layer 251 and the passivation layer 247 so as to directly contact the first drain electrode 246 of the second transistor 240.

The light-emitting element 260 may be formed on the planarization layer 250. For example, the light-emitting element 260 may be disposed on the second planarization layer 252. The light-emitting element 260 may include a first electrode 261, a light-emitting layer 263, a second electrode 265, and a capping layer 267.

The light-emitting element 260 may be electrically connected to the pixel driving circuit via the first electrode 261. For example, the first electrode 261 may extend through the second planarization layer 252 so as to directly contact the pixel contact electrode 255. Accordingly, the first electrode 261 may be electrically connected to the second transistor 240 via the pixel contact electrode 255. However, FIG. 2 is indented for illustrating an example of a scheme of supplying a current to the first electrode 261, and the present disclosure is not limited to physical contact between the second transistor 240 as the driving transistor and the first electrode 261. As an example, the second transistor 240 electrically connected to the first electrode 261 may be a light-emission transistor. For example, the light-emission transistor may control the turn-on and turn-off states of the light-emitting element 260. The pixel contact electrode 255 may include a conductive material. For example, the pixel contact electrode 255 may include one or more metal materials, such as aluminum (Al), chromium (Cr), copper (Cu), titanium (Ti), molybdenum (Mo), and tungsten (W). In an example, the pixel contact electrode 255 may have a multilayer structure of titanium layer/aluminum layer/titanium layer (Ti/Al/Ti).

The first electrode 261 may include a transparent conductive layer. For example, the first electrode 261 may include ITO (Indium Tin Oxide) or IZO (Indium Zinc Oxide). Alternatively, the first electrode 261 may have a single-layer or a multi-layer structure including a reflective metal film made of one of silver (Ag), aluminum (Al), gold (Au), nickel (Ni), and chromium (Cr) or an alloy thereof. The first electrode 261 may also be referred to as a pixel electrode or an anode electrode.

A bank 262 may be disposed on the first electrode 261. The bank 262 may be disposed to cover an edge of the first electrode 261. A portion of the bank 262 may extend to the second planarization layer 252. A portion of an upper surface of the first electrode 261 not covered with the bank 262 so as to be exposed may be the light emission area EA. The bank 262 may be made of an organic insulating material. The bank 262 may include, for example, photosensitive polyimide, photoacryl, or benzocyclobutene (BCB).

A spacer 264 may be further disposed on the bank 262. The spacer 264 may be disposed to prevent damage to the bank 262 and the first electrode 261 during the process. The spacer 264 may be made of the same material as that of the bank 262.

The light-emitting layer 263 may be disposed on the first electrode 261. The light-emitting layer 263 may include a hole transport layer HTL, an organic light-emitting layer EML, an electron transport layer ETL, a hole blocking layer HBL, a hole injecting layer HIL, an electron blocking layer EBL, and an electron injecting layer EIL. The light light-emitting layer 263 may have a multi-stack structure in which two or more organic emission layers EML are stacked.

The second electrode 265 may be disposed on the light-emitting layer 263. The second electrode 265 may be commonly connected to the light-emitting layer 263 formed in all pixels. Therefore, the second electrode 265 may also be referred to as a common electrode or a cathode electrode. The second electrode 265 may include a transflective conductive material. For example, the second electrode 265 may be made of a metal material such as magnesium (Mg), silver (Ag), or an alloy (Ag-Mg) of silver (Ag) and magnesium (Mg). In an example, the second electrode 265 may include a transparent conductive layer such as indium-tin-oxide (ITO) or indium-zinc-oxide (IZO).

The capping layer 267 may be disposed on the second electrode 265. The capping layer 267 may prevent light generated from the light-emitting layer 263 from being lost, thereby improving light extraction efficiency.

The encapsulation stack 270 may be disposed on the light-emitting element 260. The encapsulation stack 270 may protect the light-emitting element 260 from external oxygen or moisture. The encapsulation stack 270 may extend to the non-display area NAA outside the display area AA while covering the display area AA.

The encapsulation stack 270 may include a multilayer structure in which a first encapsulation layer 271, a second encapsulation layer 273, and a third encapsulation layer 275 are stacked. The second encapsulation layer 273 may be disposed between the first encapsulation layer 271 and the third encapsulation layer 275.

The first encapsulation layer 271 may be disposed on the capping layer 267. The second encapsulation layer 273 may be disposed on the first encapsulation layer 271. The second encapsulation layer 273 may cover the first encapsulation layer 271 and may have a sufficient thickness so as to have a flat upper surface. The second encapsulation layer 273 may prevent foreign substances from penetrating into the light-emitting element 260. The third encapsulation layer 275 may be disposed on the second encapsulation layer 273. Each of the first encapsulation layer 271 and the third encapsulation layer 275 may extend to the link area LKA.

Each of the first encapsulation layer 271 and the third encapsulation layer 275 may include an inorganic insulating material, and the second encapsulation layer 273 may include an organic insulating material. For example, each of the first encapsulation layer 271 and the third encapsulation layer 275 may include at least one of silicon nitride (SiNx), silicon oxide (SiOx), or silicon oxynitride (SiON). The second encapsulation layer 273 may include at least one of epoxy, polyimide, polyethylene, and acrylate.

A touch area may be disposed on the encapsulation stack 270. The touch area may include a touch buffer layer 277, a touch sensor 287, a touch interlayer insulating layer 282, a first touch protective layer 290, and a second touch protective layer 295.

The touch buffer layer 277 may be disposed on the third encapsulation layer 275. The touch buffer layer 277 may reduce stress between the encapsulation stack 270 and the layer of the touch sensor 287 to prevent the encapsulation stack 270 and the light-emitting element 260 from being damaged. The touch buffer layer 277 may include an inorganic insulating material. For example, the touch buffer layer 277 may include silicon nitride (SiNx).

The touch sensor 287 may include a plurality of touch electrodes 285 and a bridge electrode 281. The plurality of touch electrodes 285 and the bridge electrode 281 may be disposed in different layers. For example, the bridge electrode 281 may be disposed on the touch buffer layer 277. The plurality of touch electrodes 287 may be disposed on the touch interlayer insulating layer 282. The plurality of touch electrodes 287 may include a first touch electrode 283 and a second touch electrode 284. The bridge electrode 281 may electrically connect adjacent first touch electrodes 283 to each other. To this end, the first touch electrode 283 may extend through the touch interlayer insulating layer 282 so as to be connected to the bridge electrode 281. The touch interlayer insulating layer 282 may include an inorganic insulating material. For example, the touch interlayer insulating layer 282 may include silicon nitride (SiNx).

The first touch electrode 283, the second touch electrode 284, or the bridge electrode 281 may include a conductive material. The first touch electrode 283, the second touch electrode 284, or the bridge electrode 281 may include a single layer or a stack of multiple layers made of one of molybdenum (Mo), aluminum (Al), chromium (Cr), gold (Au), titanium (Ti), nickel (Ni), neodymium (Nd), and copper (Cu) or an alloy thereof.

Each of the touch buffer layer 277 and the touch interlayer insulating layer 282 may extend toward the non-display area NAA. The touch buffer layer 277 and the touch interlayer insulating layer 282 may be vertically stacked so as to be in contact with each other in the non-display area NAA to constitute a touch insulating structure 280. In one example, the touch insulating structure 280 may extend to the link area LKA.

The first touch protective layer 290 may be disposed on the touch sensor 287. The first touch protective layer 290 may prevent damage to the touch sensor 287 from external impact and moisture. The first touch protective layer 290 may include an organic insulating material. For example, the first touch protective layer 290 may be made of a photosensitive acrylic-based or polyimide-based organic material. The first touch protective layer 290 may extend to the non-display area NAA. For example, the first touch protective layer 290 may extend to the link area LKA.

The second touch protective layer 295 may be disposed on the first touch protective layer 290. The second touch protective layer 295 may further protect the touch sensor 287 from external impact and moisture. In addition, the second touch protective layer 295 (or the first touch protective layer 290) may planarize a step caused by patterns constituting the touch sensor 287 disposed thereunder. The second touch protective layer 295 may include an organic insulating material. For example, the second touch protective layer 295 may include the same organic insulating material as that of the first touch protective layer 290. However, embodiments of the present disclosure are not limited thereto. For example, the second touch protective layer 295 may include an organic insulating material different from that of the first touch protective layer 290 or may include an inorganic insulating material.

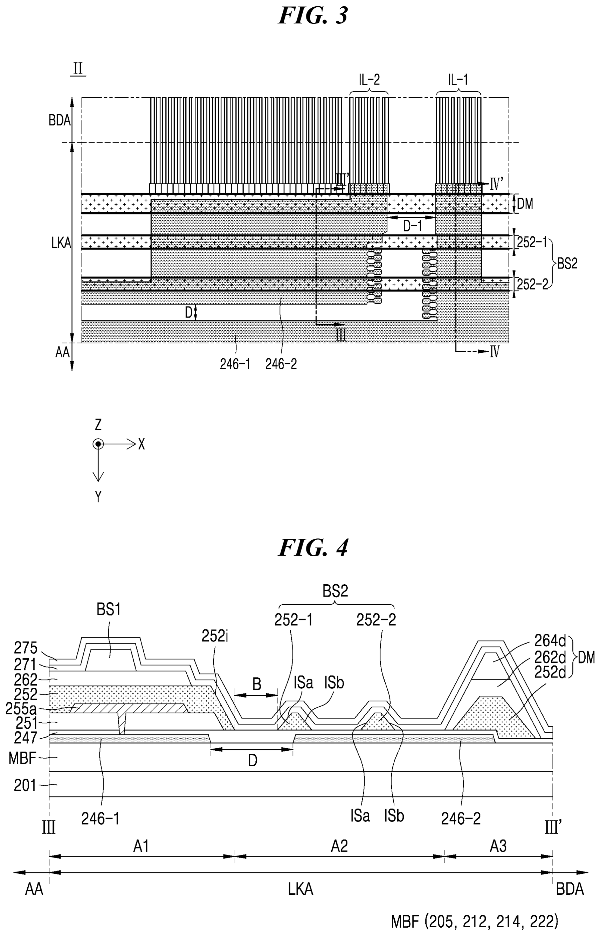

FIG. 3 is an enlarged view of an area II of FIG. 1. FIG. 4 is a diagram of a first embodiment of the disclosure. FIG. 4 is a cross-sectional view taken along a line III-III' of FIG. 3. For example, FIG. 4 may illustrate a cross-section of a portion of the non-display area AA disposed in a lower end of the display panel 200 (see FIG. 1). In FIG. 4, for convenience of illustration, the touch area disposed on the third encapsulation layer 275 is omitted from the drawings. In FIG. 3, the Y direction is shown reversed for convenience of illustration.

Referring to FIGS. 3 and 4, a multi-buffer layer MBF may be disposed on the substrate 201 of the link area LKA. The multi-buffer layer MBF may include one or more insulating layers extending from the display area AA. For example, the multi-buffer layer MBF may include the first buffer layer 205, the second buffer layer 212, the first gate insulating layer 222, and the first interlayer insulating layer 214. However, embodiments of the disclosure are not limited thereto.

A first signal line 246-1 and a second signal line 246-2 may be disposed on the multi-buffer layer MBF. The first signal line 246-1 and the second signal line 246-2 may be disposed on the same plane. The first signal line 246-1 may be a low potential power (VSS) line, and the second signal line 246-2 may be a high potential power (VDD) line.

As illustrated in FIG. 3, the first signal line 246-1 and the second signal line 246-2 may be disposed to be spaced apart from each other in the second direction Y with an isolation space D therebetween. For example, in the isolation space D, the first signal line 246-1 and the second signal line 246-2 may be disposed to be spaced apart from each other in the second direction Y in which the display area AA, the link area LKA, and the bendable area BDA are arranged.

In addition, the first signal line 246-1 and the second signal line 246-2 may be disposed in the link area LKA so as to be spaced apart from each other in the first direction X with another isolation space D-1 therebetween. The first direction X intersects with the second direction Y in the plan view of the display device. One end of the first signal line 246-1 may be electrically connected to first interconnect lines IL-1. The first interconnect lines IL-1 may extend across the bendable area BDA to the pad area PDA. One end of the second signal line 246-2 may be electrically connected to second interconnect lines IL-2. The second interconnect lines IL-2 may extend across the bendable area BDA to the pad area PDA. The space D between the first and second signal line 246-1 and 246-2 in Y direction may be smaller than the space D-1 in X direction. As shown in Figure 3 the space D is fully arranged in the LKA area, i.e. outside of the display area AA.

Each of the first signal line 246-1 and the second signal line 246-2 may be made of the same material as that of and/or be formed in the same process as that of the first source electrode 224 or the first drain electrode 225. For example, each of the first signal line 246-1 and the second signal line 246-2 may be embodied as a single layer or a stack of multiple layers made of one of molybdenum (Mo), aluminum (Al), chromium (Cr), gold (Au), titanium (Ti), nickel (Ni), neodymium (Nd), and copper (Cu), or an alloy thereof. However, embodiments of the disclosure are not limited thereto. In an example, each of the first signal line 246-1 and the second signal line 246-2 may have a stacked structure of titanium layer/aluminum layer/titanium layer (Ti/Al/Ti).

A passivation layer 247 may be disposed on the first signal line 246-1 and the second signal line 246-2. A first planarization layer 251 and a second planarization layer 252 may be disposed on the passivation layer 247 and may overlap each other in a vertical direction. An end of the second planarization layer 252 may cover an end of the first planarization layer 251. A lateral end of the second planarization layer 252 extending from the display area AA to the link area LKA may have an inclined side surface 252i having an inclination.

A connection line 255a may be disposed between the first planarization layer 251 and the second planarization layer 252 in vertical direction. The connection line 255a may be made of the same material as that of and be formed in the same process as that of the pixel contact electrode 255 of the display area AA. For example, the connection line 255a may include a stack of multiple layers of titanium layer/aluminum layer/titanium layer (Ti/Al/Ti). The connection line 255a may extend through the first planarization layer 251 and the passivation layer 247 so as to be electrically connected to the first signal line 246-1.

The bank 262 may be disposed on the second planarization layer 252. A first barrier structure BS1 may be disposed on the bank 262. In the display area AA the bank 262 is used to separate the light mitting areas of the subpixels from each other. The first barrier structure BS1 may be made of the same material as that of and be formed in the same process as that of the spacer 264 of the display area AA.

A dam DM and a second barrier structure BS2 may be disposed in the link area LKA between the display area AA and the bendable area BDA. The link area LKA may include a first area A1, a second area A2, and a third area A3. The first area A1 of the link area LKA may be positioned at a position closest to the display area AA. The third area A3 of the link area LKA may be positioned at a position closest to the bendable area BDA. The second area A2 may be disposed between the first area A1 and the third area A3.

The first barrier structure BS1 may be disposed in the first area A1 of the link area LKA. In an example, the first planarization layer 251, the second planarization layer 252, the bank 262, and the first barrier structure BS1 disposed in the first area A1 may be referred to as an organic insulating structure. The dam DM may be disposed in the third area A3 of the link area LKA.

The dam DM may have a structure in which a first dam layer 252d, a second dam layer 262d, and a third dam layer 264d are sequentially and vertically stacked. For example, the first dam layer 252d may be made of the same material as that of and be formed in the same process as that of the second planarization layer 252. The second dam layer 262d may be made of the same material as that of and be formed in the same process as that of the bank 262. The third dam layer 264d may be made of the same material as that of and be formed in the same process as that of the spacer 264. A partial area of the first dam layer 252d may overlap the second signal line 246-2. The second dam layer 262d may cover the upper surface and both side surfaces of the first dam layer 252d. The third dam layer 264d may be disposed on the second dam layer 262d.

The second barrier structure BS2 may be disposed in the second area A2 of the link area LKA. For example, the second barrier structure BS2 may be disposed between the first barrier structure BS1 and the dam DM in the plan view. The second barrier structure BS2 may include at least two barriers 252-1 and 252-2. The barriers 252-1 and 252-2 may include a first barrier 252-1 and a second barrier 252-2. The first barrier 252-1 and the second barrier 252-2 may be spaced apart from each other such that each of the first barrier 252-1 and the second barrier 252-2 has an island pattern shape. Each of the first barrier 252-1 and the second barrier 252-2 may have a line shape surrounding the display area AA. The first barrier 252-1 may be located outwardly (i.e., farther away from the display area AA) from the first barrier structure BS1, and the second barrier 252-2 may be located inwardly (i.e., closer to the display area AA) from the dam DM in the plan view.

A lower surface of each of the first barrier 252-1 and the second barrier 252-2 may have a width relatively greater than that of an upper surface thereof. Accordingly, the first barrier 252-1 may include inclined side surfaces ISa and ISb extending between the upper surface and the lower surface thereof. The second barrier 252-2 may include inclined side surfaces ISa and ISb extending between the upper surface and the lower surface thereof.

Each of the first barrier 252-1 and the second barriers 252-2 may be made of the same material as that of and be formed in the same process as that of the second planarization layer 252. Accordingly, the second barrier structure BS2 may include an organic insulating material.

The high potential power (VDD) line which is the first signal line 246-1 may supply power to the light-emitting element or provide a voltage required for the operation of the driving circuit and the light-emitting element. The low potential power (VSS) line which is the second signal line 246-2 may provide a reference voltage to the light-emitting element disposed in the display area AA. The low-potential power (VSS) line may be disposed to surround the display area AA to lower resistance thereof.

As a size of the bezel area BZA the display panel 200 decreases, the isolation space D defined between the first signal line 246-1 and the second signal line 246-2 disposed at the lower end of the display panel 200 may also be smaller. For example, as the display panel of the watch phone is configured to have a narrow bezel area, the isolation space D between the first signal line 246-1 and the second signal line 246-2 for controlling the operation of the watch phone may be narrower.

When the isolation space D is smaller, a defect in which the first signal line 246-1 and the second signal line 246-2 come into contact with each other such that a short-circuit therebetween occurs may occur.

In addition, a plurality of link lines may be disposed under the first signal line 246-1 and the second signal line 246-2. Each of the plurality of link lines may include a multi-layer structure of multiple layers overlapping each other in the vertical direction. The plurality of link lines may transmit signals provided from the driving circuit chip 104 on the flexible printed circuit board 103 (see FIG. 1) connected to the pad area PDA (see FIG. 1) to the display area AA.

In this regard, because the plurality of link lines are disposed under the first signal line 246-1 and the second signal line 246-2, a residual film may remain without being removed in an etching process for isolating the first signal line 246-1 and the second signal line 246-2 from each other. Thus, a defect such as a short-circuit between the first signal line 246-1 and the second signal line 246-2 due to the residual film may occur.

A method of maximally increasing a length of the isolation space D defined between the first signal line 246-1 and the second signal line 246-2 may be considered as one of methods of preventing a short-circuit defect due to contact between the first signal line 246-1 and the second signal line 246-2 or a short-circuit defect due to the residual film from occurring.

For example, according to an embodiment of the disclosure, the isolation space D may be defined in an area different from an area in which the inclined side surface of the organic insulating structure is disposed. In an example, the isolation space D may be defined not to overlap the inclined side surface 252i of the second planarization layer 252 of the organic insulating structure. As the inclined surface of the organic insulating structure which might be also called side surface of the organic insulating structure is an area having nearly no conducting lines the arrangement of the space d in this area is most efficient to further increase the distance between conducting lines or to reduce the risk of a short circuit due to any remaining conducting lines.

However, the method of increasing a length of the isolation space D defined between the first signal line 246-1 and the second signal line 246-2 may cause a problem in that the display panel 200 may be weakened by an external force. For example, the first signal line 246-1 may be disposed in the first area A1. Accordingly, the end of the first signal line 246-1 may be located more inwardly toward the display area AA than the inclined side surface 252i of the second planarization layer 252 and the end of the first planarization layer 251 may be. One end of the second signal line 246-2 may be spaced apart from the end of the first signal line 246-1 and may extend toward the bendable area BDA.

The isolation space D defined between the first signal line 246-1 and the second signal line 246-2 may vertically non-overlap the inclined side surface 252i of the second planarization layer 252 of the organic insulating structure. In addition, the end of the second signal line 246-2 may overlap a second inclined side surface ISb of the first barrier 252-1, but may vertically non-overlap a first inclined side surface ISa thereof. Accordingly, an open area in which a structure is not supported by a material such as metal may occur in the isolation space D defined between the first signal line 246-1 and the second signal line 246-2. The open area may be referred to as an in-between area B disposed between the inclined side surface 252i of the second planarization layer 252 and the first inclined side surface ISa of the first barrier 252-1.

Since the link area LKA in which the first signal line 246-1 and the second signal line 246-2 are disposed is disposed adjacent to the bendable area BDA, stress caused by the bending operation may be a cause of the external force applied thereto. For example, the stress due to the bending operation may be applied in the open area B, and thus, a strain may be higher. For example, a portion of the inclined side surface 252i of the second planarization layer 252 that does not overlap an end of one side of the first signal line 246-1 and a portion of the first inclined side surface ISa of the first barrier 252-1 that does not overlap an end of one side of the second signal line 246-2 may be stressed by the bending operation, and thus the strain thereof may be higher compared to that of the flat area. As the strain increases, a defect such as a crack in or damage to the portion of the inclined side surface 252i of the second planarization layer 252 or the first inclined side surface ISa of the first barrier 252-1 including the organic insulating material and disposed in the in-between area B may occur.

When the moisture permeates into the portion where the crack and breakage caused by the above cause occur, corrosion of the first signal line 246-1 or the second signal line 246-2 may occur. In addition, the permeated moisture thereto may flow toward the display area AA. This may lead to a defect in which the pixel does not operate in the display area, and thus the reliability of the display device may be deteriorated.

Accordingly, in another embodiment of the disclosure, a structure capable of preventing cracks or breakage from occurring in the organic insulating layer will be described.

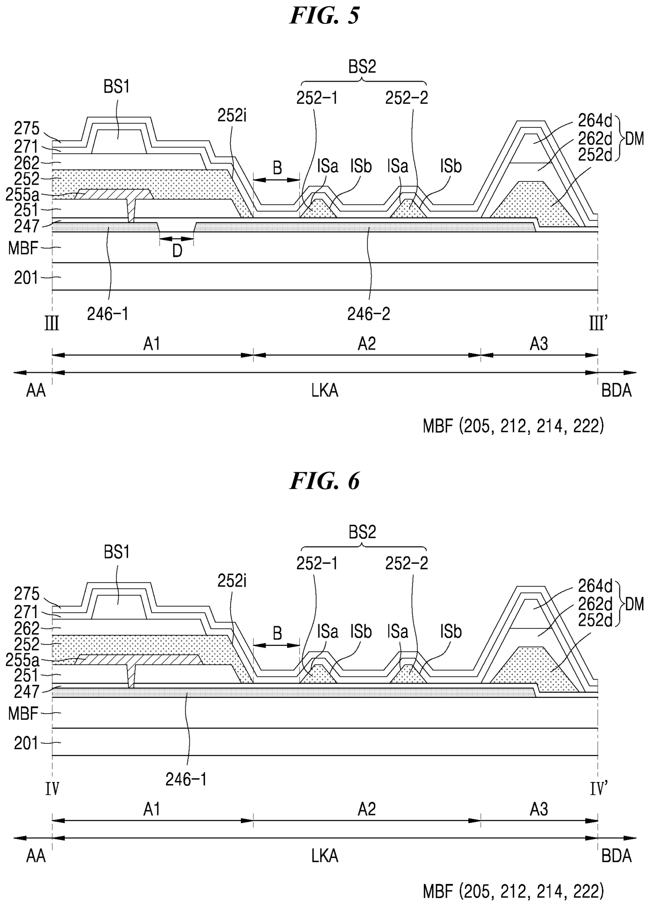

FIGS. 5 and 6 are diagrams according to a second embodiment of the disclosure. FIG. 5 is a cross-sectional view taken along a line III-III of FIG. 3, and FIG. 6 is a cross-sectional view taken along a line IV-IV' of FIG. 3. In FIGS. 5 and 6, descriptions of the same components as those of FIG. 4 will be briefly made or omitted. The same constituent elements may employ the same reference numerals. In FIGS. 5 and 6, for convenience of illustration, the touch area disposed on the third encapsulation layer 275 and interconnect lines IL-1 and IL-2 are omitted from the drawings.

Referring to FIGS. 5 and 6 together with FIG. 3, the first signal line 246-1 and the second signal line 246-2 may be disposed on the multi-buffer layer MBF.

The first signal line 246-1 and the second signal line 246-2 may be disposed so as to be spaced from each other with the isolation space D interposed therebetween. The isolation space D may vertically non-overlap the inclined side surface 252i of the second planarization layer 252 of the organic insulating structure . For example, an end of the second signal line 246-2 may extend toward the display area AA while overlapping at least the inclined side surface 252 i of the second planarization layer 252. Accordingly, the isolation space D defined between the first signal line 246-1 and the second signal line 246-2 may be disposed in an area different from the area in which the inclined side surface 252i of the second planarization layer 252 is disposed. In an example, the isolation space D defined between the first signal line 246-1 and the second signal line 246-2 may vertically non-overlap the inclined side surface 252i of the second planarization layer 252 and may be disposed in the first area A1 in which the first barrier structure BS1 is disposed.

The first barrier 252-1 and the second barrier 252-2 of the second barrier structure BS2 may overlap the second signal line 246-2 in the vertical direction. For example, the second signal line 246-2 may vertically overlap the first inclined side surface ISa and the second inclined side surface ISb of the first barrier 252-1 and the first inclined side surface ISa and the second inclined side surface ISb of the second barrier 252-2.

Accordingly, the second area A2 may be supported by a material having relatively rigidity, such as a metal. For example, the area B2 between the inclined side surface 252i of the second planarization layer 252 and the first inclined side surface ISa of the first barrier 252-1, the second barrier structure BS2, and an area between the second inclined side surface ISb of the second barrier 252-2 and the inclined side surface of the dam DM may be supported by the second signal line 246-2 disposed thereunder.

Therefore, even when the display panel is bent in the bendable area BDA, the cracks may be prevented from occurring in the inclined side surface 252i of the second planarization layer 252 or the first inclined side surface ISa of the first barrier 252-1 or the damage to the inclined side surface 252i of the second planarization layer 252 or the first inclined side surface ISa of the first barrier 252-1 may be prevented. This may prevent moisture from penetrating into the first signal line 246-1 or the second signal line 246-2 or flowing toward the display area AA. This may prevent a defect in which the pixel does not operate in the display area DA. In addition, the isolation space D is disposed between the first signal line 246-1 and the second signal line 246-2, thereby preventing the short-circuit between the first signal line 246-1 and the second signal line 246-2 via contact of the first signal line 246-1 and the second signal line 246-2 with each other.

Therefore, the defect rate of the display device due to the corrosion of the signal lines or the short-circuit between the signal lines is reduced, and thus production energy required for the production of the display device can be reduced, thereby reducing the emission of greenhouse gas. In addition, the isolation space D defined between the signal lines 246-1 and 246-2 is defined in the narrow bezel area in which the signal lines for controlling the operation of the watch phone are disposed, thereby preventing the short-circuit between the first signal line 246-1 and the second signal line 246-2 via contact of the first signal line 246-1 and the second signal line 246-2 with each other. Accordingly, there is an effect of stably maintaining the performance of the watch phone.

Referring to FIGS. 3 and 6, the first signal line 246-1 extending from the display area AA toward the bendable area BDA along the second direction Y may continuously extend along the first area A1, the second area A2, and the third area A3 of the link area LKA without a break. Accordingly, the area B2 between the inclined side surface 252i of the second planarization layer 252 and the first inclined side surface ISa of the first barrier 252-1, the second barrier structure BS2, and an area between the second inclined side surface ISb of the second barrier 252-2 and the inclined side surface of the dam DM may be supported by the first signal line 246-1 disposed thereunder.

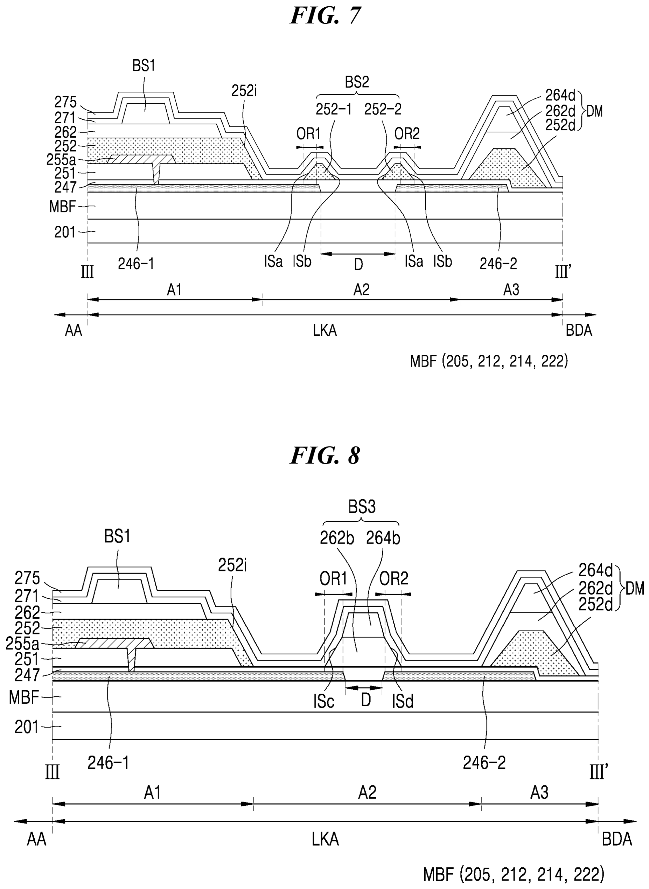

FIG. 7 is a diagram according to a third embodiment of the disclosure. FIG. 7 is a cross-sectional view taken along a line III-III' of FIG. 3. In FIG. 7, descriptions of the same components as those of FIG. 5 will be briefly made or omitted. The same constituent elements may employ the same reference numerals. In FIG. 7, for convenience of illustration, the touch area disposed on the third encapsulation layer 275 is omitted from the drawings.

Referring to FIG. 7, the first signal line 246-1 and the second signal line 246-2 may be disposed on the multi-buffer layer MBF. The isolation space D may be defined between the first signal line 246-1 and the second signal line 246-2. The first signal line 246-1 may extend from the display area AA to the link area LKA and along a portion of the link area LKA. For example, the first signal line 246-1 may extend along an entirety of the first area A1 of the link area LKA and along a partial area of the second area A2 thereof.

The first barrier 252-1 and the second barrier 252-2 may be formed as island patterns that are not connected and are spaced apart from each other. The first signal line 246-1 may include a first overlapping area OR1 overlapping at least the first inclined side surface ISa of the first barrier 252-1 of the second barrier structure BS2 in the vertical direction. The second signal line 246-2 may include a second overlapping area OR2 overlapping at least the second inclined side surface ISb of the second barrier 252-2 of the second barrier structure BS2 in the vertical direction.

Accordingly, the isolation space D defined between the first signal line 246-1 and the second signal line 246-2 may be disposed in the second area A2 in which the second barrier structure BS2 is disposed. For example, the isolation space D may vertically overlap the second inclined side surface ISb of the first barrier 252-1 and the first inclined side surface ISa of the second barrier 252-2. For example, the isolation space D may vertically non-overlap the inclined side surface 252i of the second planarization layer 252.

The isolation space D may prevent a residual film from being generated in an area between the first signal line 246-1 and the second signal line 246-2 and thus may prevent the first signal line 246-1 and the second signal line 246-2 from being electrically connected to each other. This may prevent a GDS (Gate drain short) defect caused by the generation of the conductive path including the residual film between the first signal line 246-1 and the second signal line 246-2.

The first signal line 246-1 may include the first overlapping area OR1 overlapping at least the first inclined side surface ISa of the first barrier 252-1 of the second barrier structure BS2 in the vertical direction. The second signal line 246-2 may include the second overlapping area OR2 overlapping at least the second inclined side surface ISb of the second barrier 252-2 of the second barrier structure BS2 in the vertical direction. Accordingly, the first area A1 of the link area LKA may be reinforced by a material having relatively rigidity, such as a metal. Therefore, the first area A1 may reduce or prevent cracks from occurring in the inclined side surface 252i of the second planarization layer 252 or the first inclined side surface ISa of the first barrier 252-1 during the bending operation or may reduce or prevent the damage to the inclined side surface 252i of the second planarization layer 252 or the first inclined side surface ISa of the first barrier 252-1 during the bending operation. In addition, even when the crack occurs in an area between the first barrier 252-1 and the second barrier 252-2 in the second area A2 such that the moisture permeates through the cracks, the first signal line 246-1 may block the moisture and prevent the moisture from flowing toward the second planarization layer 252. This may reduce or prevent moisture from flowing toward the display area AA, thereby reducing or preventing an operation failure of the display device from occurring.

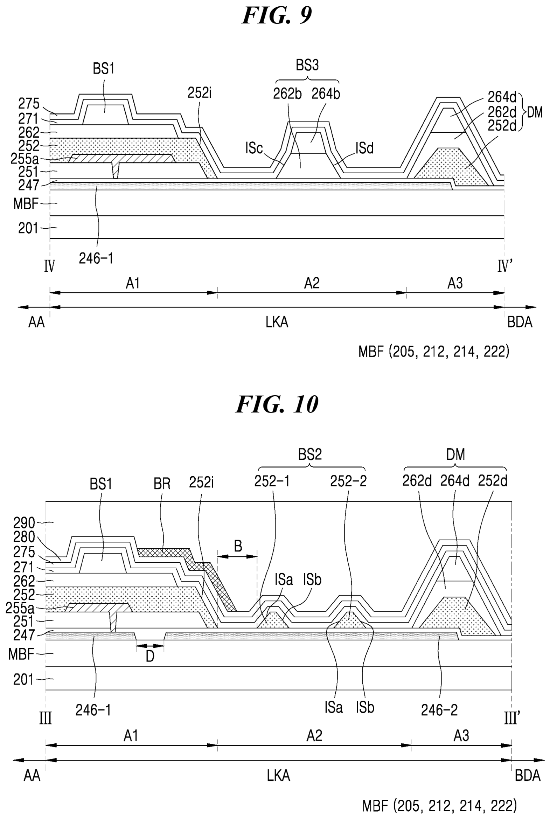

FIGS. 8 and 9 are diagrams according to a fourth embodiment of the disclosure. FIG. 8 is a cross-sectional view taken along a line III-III of FIG. 3. FIG. 9 is a cross-sectional view taken along a line IV-IV' of FIG. 3. In FIGS. 8 and 9, descriptions of the same components as those of FIGS. 5 and 6 will be briefly made or omitted. The same constituent elements may employ the same reference numerals. In FIGS. 8 and 9, for convenience of illustration, the touch area disposed on the third encapsulation layer 275 and the interconnect lines IL-1 and IL-2 are omitted from the drawings.

Referring to FIGS. 8 and 9, a third barrier structure BS3 may be disposed in the second area A2 of the link area LKA. For example, the third barrier structure BS3 may be disposed between the first barrier structure BS1 and the dam DM in the plan view. In an example, the third barrier structure BS3 may be formed as one island-type line pattern. For example, the third barrier structure BS3 may have a line pattern shape surrounding the outside of the display area AA.

The third barrier structure BS3 may include a first layer 262b and a second layer 264b on the first layer 262b. The first layer 262b of the third barrier structure BS3 may be made of the same material as that of and be formed in the same process as that of the bank 262. In addition, the second layer 264b may be made of the same material as that of and be formed in the same process as that of the spacer 264. Accordingly, the third barrier structure BS3 may include an organic insulating material.

A lower surface of the first layer 262b of the third barrier structure BS3 may have a relatively greater width than that of an upper surface thereof. Accordingly, the third barrier structure BS may include both opposing inclined side surfaces ISc and ISd opposite to each other in the Y direction. Each of both opposing inclined side surfaces ISc and ISd may extend between the upper surface and the lower surface of the third barrier structure BS3. For example, the inclined side surfaces ISc and ISd may include a first inclined side surface ISc and a second inclined side surface ISd opposite to the first inclined side surface ISc in the Y direction.

The first signal line 246-1 and the second signal line 246-2 may be disposed on the multi-buffer layer MBF of the substrate 201. The isolation space D may be defined between the first signal line 246-1 and the second signal line 246-2. The isolation space D may vertically non-overlap a portion of the inclined side surface 252i of the second planarization layer 255. In addition, the isolation space D may vertically non-overlap each of the inclined side surfaces ISc and ISd of the third barrier structure BS3.

The first signal line 246-1 may extend from the display area AA to the link area LKA and along an entirety of the first area A1 and along a portion of the second area A2 of the link area LKA. An end of one side of the first signal line 246-1 disposed in the second area A2 of the link area LKA may include a first overlapping area OR1 at least partially overlapping the first layer 262b of the third barrier structure BS3. For example, the first overlapping area OR1 may be an area overlapping the first inclined side surface ISc of the first layer 262b of the third barrier structure BS3. In addition, an end of one side of the second signal line 246-2 disposed in the second area A2 may include a second overlapping area OR2 at least partially overlapping the first layer 262d of the third barrier structure BS3. For example, the second overlapping area OR2 may be an area overlapping the second inclined side surface ISd of the first layer 262b of the third barrier structure BS3.

The isolation space D defined between the first signal line 246-1 and the second signal line 246-2 may be disposed in the second area A2 of the link area LKA in which the third barrier structure BS3 is disposed. The isolation space D does not overlap the inclined side surface 252i of the second planarization layer 252, thereby preventing an increase in strain at the inclined side surface 252i of the second planarization layer 252. This may prevent cracks from occurring due to an increase in strain. This may prevent defects from occurring in the display device due to the corrosion of the signal lines due to the penetration of moisture into the portion where the crack has occurred.

The isolation space D may prevent a residual film from being generated in the area between the first signal line 246-1 and the second signal line 246-2 and thus may prevent the first signal line 246-1 and the second signal line 246-2 from being electrically connected to each other and thus being short-circuited therebetween. This may prevent a gate drain short-circuit (GDS) defect caused by the residual film formed between the first signal line 246-1 and the second signal line 246-2 from occurring.

In addition, even when the crack occurs in the third barrier structure BS3 including the organic insulating material such that the moisture penetrates through the crack formed in the third barrier structure BS3, the passivation layer 247 including the inorganic insulating material disposed in at least the first overlap area OR1 may block the moisture to prevent the moisture from flowing toward the second planarization layer 252. This may prevent the first signal line 246-1 or the second signal line 246-2 from being corroded due to the moisture penetration. Therefore, the defect rate of the display device due to corrosion of the signal lines or short-circuit between the signal lines is reduced, and thus production energy required for the production of the display device can be reduced, thereby reducing the emission of greenhouse gas.

Referring to FIGS. 3 and 9, the first signal line 246-1 extending from the display area AA toward the bendable area BDA along the second direction Y may continuously extend along the first area A1, the second area A2, and the third area A3 of the link area LKA without a break. Accordingly, the area between the inclined side surface 252i of the second planarization layer 252 and the third inclined side surface ISc of the first layer 262b of the third barrier structure BS3, the third barrier structure BS3, and an area between the fourth inclined side surface ISd of the first layer 262b of the third barrier structure BS3 and the inclined side surface of the dam DM may each be supported by the first signal line 246-1 disposed thereunder.

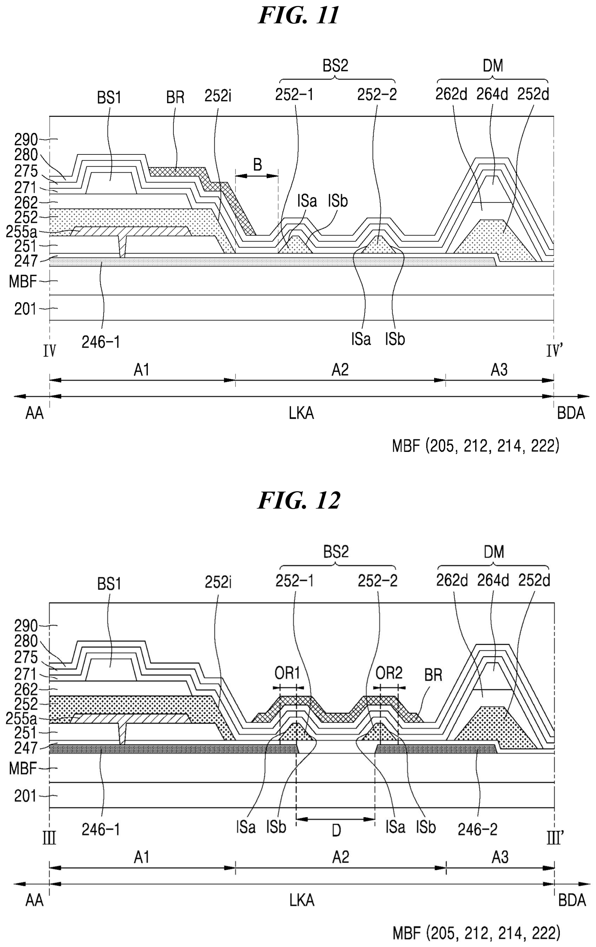

FIGS. 10 and 11 are diagrams illustrating a fifth embodiment of the disclosure. FIG. 10 is a cross-sectional view taken along a line III-III' of FIG. 3, and FIG. 11 is a cross-sectional view taken along a line IV-IV' of FIG. 3. In FIGS. 10 and 11, descriptions of the same components as those of FIGS. 5 and 6 will be briefly made or omitted. The same constituent elements may employ the same reference numerals.

Referring to FIGS. 10 and 11 together with FIG. 2, the touch insulating structure 280 disposed on the third encapsulation layer 275 may extend from the display area AA to the link area LKA. For example, the touch insulating structure 280 may extend along the first area A1 in which the first barrier structure BS1 is disposed, the second area 12 in which the second barrier structure BS2 is disposed, and the third area 13 in which the dam DM is disposed.

The touch protective layer 290 may be disposed on the touch insulating structure 280. The touch insulating structure 280 may include the touch buffer layer 277 and the touch interlayer insulating layer 282. However, embodiments of the present disclosure are not limited thereto.

A barrier reinforcement pattern BR may be disposed on a portion of the touch insulating structure 280 corresponding to the first area A1 of the link area LKA. The barrier reinforcement pattern BR may include the same material as that of the touch electrode 285 or the bridge electrode 281. For example, the barrier reinforcement pattern BR may include a single layer or a stack of multiple layers made of any one of molybdenum (Mo), aluminum (Al), chromium (Cr), gold (Au), titanium (Ti), nickel (Ni), neodymium (Nd), and copper (Cu) or an alloy thereof.

The barrier reinforcement pattern BR may extend along steps defined by the first barrier structure BS1, the bank 262, and the inclined side surface 252i of the second planarization layer 252 in the first area A1.

Accordingly, the barrier reinforcement pattern BR may prevent moisture or foreign substances from penetrating from the first touch protective layer 290 to the inclined side surface 252i of the second planarization layer 252 in the first area A1 of the link area LKA.

In addition, the isolation space D defined between the first signal line 246-1 and the second signal line 246-2 may vertically non-overlap the inclined side surface 252i of the second planarization layer 252. For example, the isolation space D may be located inwardly of the inclined side surface 252i of the second planarization layer 252. To this end, the second signal line 246-2 may extend so that an end thereof is positioned inwardly of (i.e., closer to the active area AA than) the inclined side surface 252i of the second planarization layer 252. Accordingly, since the second area A2 may be reinforced by a material having relatively rigidity such as a metal or the like, stress applied to the inclined side surface 252i of the second planarization layer 252 when the display panel is bent in the bendable area BA may be prevented from increasing. Accordingly, the cracks may be prevented from occurring at the end of the second planarization layer layer 252 or the first inclined side surface ISa of the first barrier 252-1 or the damage thereto may be suppressed, thereby preventing the generation of a moisture permeation path through which moisture penetrates. In addition, the first signal line 246-1 and the second signal line 246-2 may be prevented from being in contact with each other and being short-circuited with each other due the presence of the isolation space D.

Referring to FIG. 11, the first signal line 246-1 may continuously extend along the first area A1, the second area A2, and the third area A3 of the link area LKA without a break. In addition, the barrier reinforcement pattern BR may be disposed on a portion of the touch insulating structure 280 corresponding to the first area A1 of the link area LKA and may protect the inclined side surface 252i of the second planarization layer 252 from moisture or foreign substances. Accordingly, the first signal line 246-1 or the second signal line 246-2 may function as a robust structure capable of maintaining stable and reliable performance of the display device even when external environmental changes or conditions change.

FIGS. 12 to 14 are diagrams of further embodiments of the disclosure. FIG. 12 is a cross-sectional view of a sixth embodiment of the disclosure. FIG. 12 is a cross-sectional view taken along a line III-III' of FIG. 3. In FIG. 12, descriptions of the same components as those of FIG. 7 will be briefly made or omitted. The same constituent elements may employ the same reference numerals.

Referring to FIG. 12, the touch insulating structure 280 may extend along the first area A1 in which the first barrier structure BS1 is disposed, the second area A2 in which the second barrier structure BS2 is disposed, and the third area A3 in which the dam DM is disposed. The touch protective layer 290 may be disposed on the touch insulating structure 280.

The isolation space D defined between the first signal line 246-1 and the second signal line 246-2 may vertically non-overlap the inclined side surface 252i of the second planarization layer 252. The isolation space D may be defined in the second area A2 of the link area LKA and may overlap the second inclined side surface ISb of the first barrier 252-1 of the second barrier structure BS2 and the first inclined side surface ISa of the second barrier 252-2. Accordingly, the first signal line 246-1 may include the first overlapping area OR1 overlapping the first inclined side surface ISa of the first barrier 252-1 in the vertical direction, and the second signal line 246-2 may include the second overlapping area OR2 overlapping the second inclined side surface ISb of the second barrier 252-2 in the vertical direction.

The barrier reinforcement pattern BR may be disposed on a portion of the touch insulating structure 280 corresponding to the second area A2 of the link area LKA. The barrier reinforcement pattern BR may include the same material as that of the touch electrode 285 or the bridge electrode 281.

The barrier reinforcement pattern BR may be disposed to overlap the area in which the second barrier structure BS2 is disposed in the second area A2 in the vertical direction. For example, the barrier reinforcement pattern BR may extend with continuity from the first barrier 252-1 to the second barrier 252-1 of the second barrier structure BS2.

Accordingly, the barrier reinforcement pattern BR may reduce or prevent moisture or foreign substances from penetrating from the first touch protective layer 290 toward the second barrier structure BS2 in the second area A2 of the link area LKA. In addition, the barrier reinforcement pattern BR includes a metal material having relatively rigidity, thereby reducing or preventing damage to the second barrier structure BS2 due to impact from the outside of the first touch protective layer 290. For example, a stepped portion generated in a space between the first barrier 252-1 and the second barrier 252-2 may be reinforced by the barrier reinforcement pattern BR. This may reduce or prevent cracks from occurring in the space between the first barrier 252-1 and the second barrier 252-2 overlapping the isolation space D. This may reduce or prevent the generation of the moisture permeation path through the crack.

Accordingly, the barrier reinforcement pattern BR may function as a robust structure that enables the first signal line 246-1 or the second signal line 246-2 to maintain stable and reliable performance thereof even under conditions in which an external environment changes.

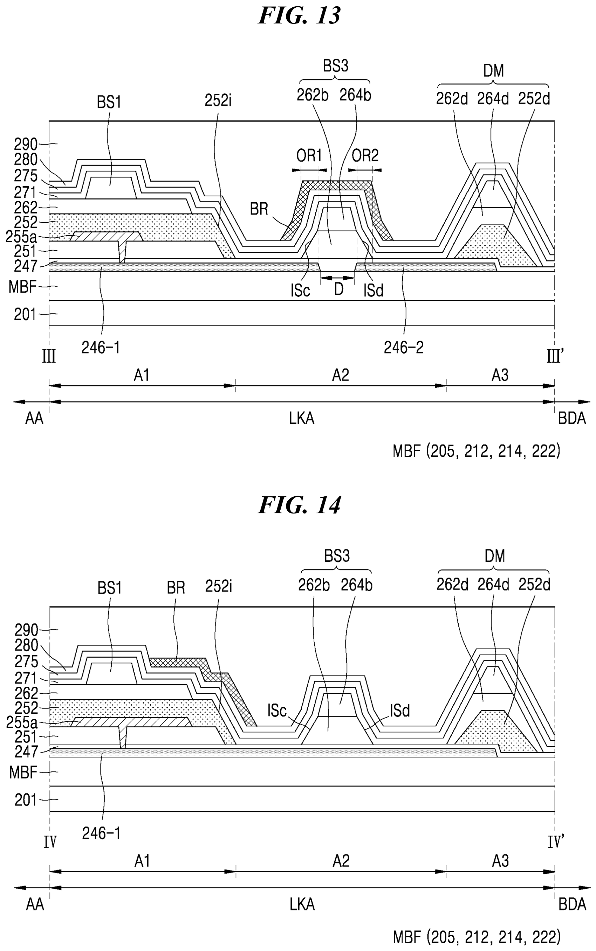

FIGS. 13 and 14 are cross-sectional views according to a seventh embodiment of the disclosure. FIG. 13 is a cross-sectional view taken along a line III-III' of FIG. 3, and FIG. 14 is a cross-sectional view taken along a line IV-IV' of FIG. 3. In FIGS. 13 and 14, descriptions of the same components as those of FIGS. 8 and 9 will be briefly made or omitted. The same constituent elements may employ the same reference numerals.

Referring to FIG. 13, the touch insulating structure 280 may extend along the first area A1 in which the first barrier structure BS1 is disposed, the second area A2 in which the third barrier structure BS3 is disposed, and the third area A3 in which the dam DM is disposed. The touch protective layer 290 may be disposed on the touch insulating structure 280. The third barrier structure BS3 may be formed as one island-type line pattern.

The barrier reinforcement pattern BR may be disposed on a portion of the touch insulating structure 280 corresponding to the second area A2 of the link area LKA. The barrier reinforcement pattern BR may include the same material as that of the touch electrode 285 or the bridge electrode 281.

The barrier reinforcement pattern BR may be disposed to overlap the area in which the third barrier structure BS3 is disposed in the vertical direction. For example, the barrier reinforcement pattern BR may overlap the first inclined side surface ISc, the upper surface, and the second inclined side surface ISd of the third barrier structure BS3.

Accordingly, the barrier reinforcement pattern BR may prevent moisture or foreign substances from penetrating from the touch protective layer 290 toward the third barrier structure BS3 in the second area A2 of the link area LKA.

The isolation space D defined between the first signal line 246-1 and the second signal line 246-2 may vertically non-overlap the inclined side surface 252i of the second planarization layer 252. For example, the isolation space D defined between the first signal line 246-1 and the second signal line 246-2 may be disposed to overlap the third barrier structure BS3. For example, the isolation space D may vertically non-overlap each of both inclined side surfaces ISc and ISd of the third barrier structure BS3. Accordingly, the isolation space D defined between the first signal line 246-1 and the second signal line 246-2 may be further reduced, such that a narrow bezel may be implemented.

The barrier reinforcement pattern BR disposed to overlap the third barrier structure BS3 may include a metal material having relatively rigidity, and thus may function as a reinforcing layer for preventing damage such as a crack from occurring in the third barrier structure BS3 due to an impact from the outside of the touch protective layer 290. Accordingly, cracks may be prevented from occurring in the third barrier structure BS3, and thus, the first signal line 246-1 or the second signal line 246-2 may be prevented from being corroded due to the moisture penetration.

Referring to FIGS. 3 and 14, the first signal line 246-1 extending from the display area AA toward the bendable area BDA along the second direction Y may continuously extend along the first area A1, the second area A2, and the third area A3 of the link area LKA without a broken portion. Accordingly, the area between the inclined side surface 252i of the second planarization layer 252 and the third inclined side surface ISc of the first layer 262b of the third barrier structure BS3, the third barrier structure BS3, and the area between the fourth inclined side surface ISd of the first layer 262b of the third barrier structure BS3 and the inclined side surface of the dam DM may each be supported by the first signal line 246-1 disposed thereunder. The barrier reinforcement pattern BR may extend along steps defined by the first barrier structure BS1, the bank 262, and the inclined side surface 252i of the second planarization layer 252 in the first area A1.

Although some embodiments of the disclosure have been described above with reference to the accompanying drawings, the disclosure may not be limited to some embodiments and may be implemented in various different forms. The skilled person in the technical field to which the disclosure belongs is able to appreciate that the disclosure may be implemented in other specific forms without changing the technical idea or essential features of the disclosure. Therefore, it should be understood that some embodiments as described above are not restrictive but illustrative in all respects.

## Claims

1. A display device comprising:
a substrate (201) including:
a display area (AA) and a non-display area (NAA) outside of the display area (AA);
a bendable area (BDA) disposed in the non-display area (NAA);
a link area (LKA) disposed between the display area (AA) and the bendable area (BDA),
wherein an organic insulating structure including an inclined side surface (252i) is disposed on the link area (LKA);
a first signal line (246-1) disposed on the link area (LKA); and
a second signal line (246-2) disposed on the link area (LKA),
wherein an isolation space (D) is defined between the first signal line (246-1) and the second signal line (246-2).

2. The display device of claim 1, wherein the isolation space (D) is disposed in a region different from a region where the inclined side surface (252i) of the organic insulating structure (251, 252) is disposed.

3. The display device of claim 1 or 2, wherein the first signal line (246-1) includes a low potential power (VSS) line, and the second signal line (246-2) includes a high potential power (VDD) line.

4. The display device of any one of the preceding claims, wherein the organic insulating structure including the inclined side surface (252i) includes:
a first planarization layer (251) disposed on the substrate (201) and extending from the display area (AA);
a second planarization layer (252) disposed on the first planarization layer (251);
a bank (262) disposed on the second planarization layer (252); and
a first barrier structure (BS1) disposed on the bank (262),
wherein a side end of the second planarization layer (252) includes an inclined side surface (252i) having an inclination.

5. The display device of any one of the preceding claims, wherein the isolation space (D) is positioned inwardly of the side end of the second planarization layer (252) and vertically nonoverlapping the inclined side surface (252i) of the second planarization layer (252).

6. The display device of any one of the preceding claims, wherein the link area (LKA) includes:
a first area (A1) on which the organic insulating structure (251, 252) is disposed;
a third area (A3) spaced apart from the first area (Al), wherein a dam (DM) is disposed on the third area (A3); and
a second area (A2) disposed between the first area (A1) and the third area (A3).

7. The display device of any one of the preceding claims, a second barrier structure (BS2) is disposed on the link area (LKA), preferably in the second area (A2), and includes a plurality of structures (252-1, 252-2) spaced apart from each other, preferably the second barrier structure (BS2) includes an organic insulating material.

8. The display device of claim 7, wherein the plurality of structures include:
a first barrier (252-1) disposed adjacent to the organic insulating structure and
a second barrier (252-2) disposed adjacent to the dam (DM),
wherein each of the first barrier (252-1) and the second barrier (252-2) has an island pattern shape and/or each of the first barrier (252-1) and the second barrier (252-2) includes an inclined side surface (ISa, ISb).

9. The display device of claim 6, 7 or 8, wherein the isolation space (D) is disposed to at least partly overlap the plurality of structures in the second area (A2) and/or the isolation space (D) overlaps one inclined side surface (ISa, ISb) of each of the first barrier (252-1) and the second barrier (252-2).

10. The display device of claim 8 or 9, wherein each of a side end of the first signal line (246-1) and a side end of the second signal line (246-2) has an inclined side surface,
wherein the inclined side surface of the first signal line (246-1) vertically overlaps the inclined side surface of the first barrier (252-1),
wherein the inclined side surface of the second signal line (246-2) vertically overlaps the inclined side surface of the second barrier (252-2).

11. The display device of any one of the preceding claims, wherein a third barrier structure (BS3) having one island pattern shape is disposed on the link area (LKA), preferably in the second area A(2), preferably the third barrier structure (BS3) includes an organic insulating material.

12. The display device of claim 11, wherein the third barrier structure (BS3) includes an upper surface, a lower surface and an inclined side surface (ISc, ISd) extending between the upper surface and the lower surface, wherein the isolation space (D) vertically non-overlaps the inclined side surface (ISc, ISd) of the third barrier structure (BS3), preferably the first signal line (246-1) includes a first overlapping area overlapping an inclined side surface (ISc, ISd) of one side of the third barrier structure (BS3), and the second signal line (246-2) includes a second overlapping area overlapping an inclined side surface (ISc, ISd) of the other side of the third barrier structure (BS3).

13. The display device of any one of the preceding claims, further comprising a barrier reinforcement pattern (BR) disposed on a portion of the organic insulating structure disposed on the link area (LKA), preferably in the first area (A1) and/or a barrier reinforcement pattern (BR) continuously extending from one of the plurality of structures disposed spaced apart from each other in the second area (A2) to another structure, preferably the barrier reinforcement pattern (BR) includes a metal material.

14. The display device of any one of the preceding claims, wherein the isolation space (D) is formed the link area (LKA) between the first signal line (246-1) and the second signal line (246-2) and extending in the second direction (Y) in which the display area (AA), the link area (LKA), and the bendable area (BDA) are arranged.

15. Watch phone including a display device as claimed in any one of the preceding claims.
